**Europäisches Patentamt**

**European Patent Office**

**Office européen des brevets**

(19)

(11) Veröffentlichungsnummer : **0 500 525 B1**

# (12) EUROPÄISCHE PATENTSCHRIFT

(45) Veröffentlichungstag der Patentschrift :
**01.09.93 Patentblatt 93/35**

(21) Anmeldenummer : **90905453.8**

(22) Anmeldetag : **30.03.90**

(86) Internationale Anmeldenummer :
**PCT/EP90/00507**

(87) Internationale Veröffentlichungsnummer :
**WO 91/07072 16.05.91 Gazette 91/11**

(51) Int. Cl.$^5$ : **H05K 3/00**

(54) **Anordnung zum Bohren von Leiterplatten.**

(30) Priorität : **06.11.89 DE 3936947**

(43) Veröffentlichungstag der Anmeldung :
**02.09.92 Patentblatt 92/36**

(45) Bekanntmachung des Hinweises auf die
Patenterteilung :
**01.09.93 Patentblatt 93/35**

(84) Benannte Vertragsstaaten :
**CH DE DK FR GB IT LI NL**

(56) Entgegenhaltungen :
**DE-A- 3 539 957**
**GB-A- 2 155 910**
**US-A- 4 824 310**

(56) Entgegenhaltungen :
**FEINWERKTECHNIK + MESSTECHNIK, Bd.**
**93, Nr. 7, October 1985, DE, Seiten 337-342; D.**
**Bärmann: "Ein Fertigungssystem zur simulta-**
**nen und seriellen Bestückung von SMD-**
**Bauteilen", siehe Seite 339, rechte Spalte,**
**Absatz 2**
**IBM TECHNICAL DISCLOSURE BULLETIN,**
**Vol. 27, No. 1A, Juni 1984, New York, US, Seite**
**435; W.F. BANKS et al.: "Incline hole pier-**
**cing", siehe das ganze Dokument**

(73) Patentinhaber : **KLG Electronic Gesellschaft**
**mbH**
**Ingenrieder Strasse 4**
**D-87600 Kaufbeuren (DE)**

(72) Erfinder : **SEITZ, Helmut**
**König-Rudolf-Str. 62**
**D-8950 Kaufbeuren (DE)**
Erfinder : **PETRICK, Gerhard**
**Gladiolenweg 3**
**D-8951 Mauerstetten (DE)**

(74) Vertreter : **Ruschke, Hans Edvard, Dipl.-Ing. et**
**al**
**Patentanwälte Ruschke & Partner**
**Pienzenauerstrasse 2**
**D-81679 München (DE)**

EP 0 500 525 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft eine Anordnung zur Beschickung von vorzugsweise einspindeligen NC-Leiterplatten-Koordinatenbohrmaschinen mit zu bohrenden Leiterplatten bzw. zum Abtransport fertig gebohrter Leiterplatten, nach dem Oberbegriff des Patentanspruches 1.

Bei der Herstellung von elektronischen Baugruppen für alle möglichen Anwendungsfälle werden sehr häufig gedruckte Schaltungen auf Leiterplatten verwendet, wobei aktive elektronische Komponenten in entsprechend angeordnete Bohrungen dieser Leiterplatten eingesetzt und dort verlötet werden. Hierfür müssen also die Leiterplatten im Zuge ihrer oft in sehr hohen Stückzahlen erfolgenden Herstellung mit diesen Bohrungen versehen werden, die je nach Art der Leiterplatte in verschiedenen Durchmessern und/oder Tiefen (z.B. bei Mehrlagenplatten) und in Stückzahlen von bis zu einigen 1000 pro Leiterplatte benötigt werden. Es liegt auf der Hand, daß eine wirtschaftliche Fertigung derartiger Leiterplatten nur im Rahmen einer stark durchrationalisierten Produktion hergestellt werden können.

Insbesondere für die Fertigung hoher Losgrößen gleichartiger Leiterplatten hat es sich weitgehend eingebürgert, mehrspindelige Koordinatenbohrmaschinen einzusetzen, die entsprechend viele Leiterplatten gleichzeitig bearbeiten. Für eine solche Bearbeitung werden gewöhnlich Pakete von mehreren Leiterplatten mit einer Auflage und Unterlage verstiftet und auf dem Aufspanntisch der Bohrmaschine nebeneinander befestigt, so daß die einzelnen Bohrspindeln der mehrspindeligen Bohrmaschine gleichzeitig die nebeneinander aufgespannten Leiterplattenpakete bearbeiten können. In Abhängigkeit von der Standzeit eines einzelnen Bohrers und von den verschiedenen Bohrungsdurchmessern etc. können je nach vorgesehenem Arbeitsablauf die Bohrwerkzeuge durch eine geeignete Werkzeugwechselvorrichtung ausgewechselt werden. Nach Beendigung des Bohrprogrammes werden die fertigen Leiterplattenpakete gewöhnlich von Hand gegen neue ungebohrte Pakete ausgetauscht.

Um die Arbeitsproduktivität solcher mehrspindliger Leiterplattenbohrmaschinen weiter zu erhöhen, wird im Stand der Technik versucht, mit Hilfe von vor der Bohrmaschine angeordneten separaten Handlingsautomaten zusätzlich einen selbsttätigen Leiterplattenwechsel vorzusehen. Dabei werden die Leiterplattenpakete durch z.B. pneumatisch betriebene Klemmvorrichtungen auf dem Arbeitstisch fixiert bzw. freigegeben.

Derart angeordnete Handlingsautomaten behindern jedoch den Zugang der Bedienungsperson zur Bohrmaschine und zum Arbeitstisch und müssen in der. Regel abgeräumt werden, um Wartungs- oder Einstellarbeiten oder dergl. an solchen relativ breiten vielspindeligen Bohrmaschinen ausführen zu können. Dies stellt eine nicht unerhebliche Beeinträchtigung der Arbeitsproduktivität solcher Anordnungen dar. Es kommt hinzu, daß mehrspindelige Leiterplatten-Bohrmaschinen nach dem Stand der Technik nur dann wirklich rationell arbeiten können, wenn große Losgrößen bearbeitet werden müssen, die auch gerade durch die Anzahl der Spindeln teilbar sein sollten. Im übrigen kommt es bei solchen mehrspindeligen Bohrmaschinen immer dann zu Produktivitätsproblemen, wenn beispielsweise an einer der Spindeln eine Störung auftritt, da dann notgedrungen während der Beseitigung dieser Störung die anderen Spindeln blockiert sind. Auch bei zahlreichen kleinen Losgrößen oder bei einer Einzelfertigung von Leiterplatten arbeiten die mehrspindeligen Leiterplatten-Bohrmaschinen unrationell.

Die US-A-4,824,310 zeigt eine Leiterplattenbohrmaschine mit vier in einer Flucht nebeneinander angeordneten Bohrspindeleinheiten, die gleichzeitig vier auf dem Werkstück nebeneinander aufgespannte Leiterplatten(pakete) bearbeiten. Diese Leiterplattenbohrmaschine ist mit einem Leiterplattenwechselsystem versehen, bei dem ein Magazin mit ungebohrten Leiterplatten an der einen (linken) Stirnseite der Bohrmaschine angeordnet ist, von wo aus die Leiterplatten zur Bearbeitung in der Bohrmaschine über den Werkstückaufspanntisch in der Fluchtlinie nacheinander zu den Bohrspindeleinheiten geschoben werden, wo sie unter der jeweiligen Bohrspindeleinheit festgeklemmt und dann bearbeitet werden. Die fertig gebohrten Leiterplatten werden dann in der gleichen Fluchtlinie bzw. Verschieberichtung über den Werkstücktisch zu einem weiteren Magazin an der anderen (rechten) Stirnseite der Leiterplattenbohrmaschine weitergeschoben. Durch die Leiterplattenmagazine an der linken und rechten Stirnseite der Bohrmaschine ist zwar der Zugang der Bedienungsperson zur Bohrmaschine und zum Werkstückaufspanntisch nicht mehr behindert, aber dieses Konzept einer vierspindeligen LP-Bohrmaschine mit einem LP-Wechselsystem wird auf jeden Fall Produktivitätsprobleme nach sich ziehen, wenn beispielsweise an einer der in einer Flucht angeordneten Spindeln eine Störung auftritt, da dann notgedrungen während der Beseitigung dieser Störung die anderen Spindeln blockiert sind.

Es ist hiernach die der vorliegenden Erfindung zugrundeliegende Aufgabe, eine Anordnung aus Leiterplatten-Bohrmaschinen und zugeordneten Leiterplatten-Wechselvorrichtungen derart weiterzubilden, daß die voranstehend erörterten Produktivitätsprobleme vermieden werden bzw. daß eine demgegenüber erhöhte Arbeitsproduktivität bei gleichzeitig verbesserter Variabilität der Bohrarbeiten erreicht wird.

Diese Aufgabe wird bei einer Anordnung der gattungsgemäß vorausgesetzten Art durch die Merkmale des kennzeichnenden Teils des Anspruches 1 gelöst. Indem kleine LP-Bohrmaschinen mit vorzugsweise ein oder

2

ggfs. zwei Bohrspindeln quasi parallel nebeneinander aufgestellt und jeweils einzelnen mit auf der Rückseite derselben angeordneten Leiterplaten-Wechselvorrichtungen versehen werden, die untereinander durch einen transferstraßenartigen Förderer verbunden sind, die ungebohrte Leiterplatten(pakete) zuförderen bzw. fertig gebohrte Leiterplatten(pakete) abfördern, wird eine wesentlich höhere Produktivität durch weniger Stillstandszeiten und eine variablere Einsetzbarkeit der einzelnen Bohrspindeln erreicht, wobei gleichzeitig der Zugang zu jeder Leiterplatten-Bohrmaschine zum Zwecke der Bedienung derselben im Vergleich zum Stand der Technik verbessert wird.

Ein Ausführungsbeispiel der vorliegenden Erfindung wird unter Bezugnahme auf die beigefügten Zeichnungen näher beschrieben. Darin zeigt:

Fig. 1     eine Seitenansicht einer an sich bekannten Leiterplatten-Koordinatenbohrmaschine, wie sie vorzugsweise in einspindeliger Ausführung im Rahmen der vorliegenden Erfindung Verwendung findet;

Fig. 2     eine Vorderansicht der gleichen Koordinatenbohrmaschine mit nur einer Bohrspndel;

Fig. 3     eine Draufsicht auf eine prinzipielle Darstellung einer erfindungsgemäßen Anordnung aus beispielsweise fünf solchen einspindeligen Koordinatenbohrmaschinen nach den Fig. 1 und 2 im Zusammenhang mit den dahinter angeordneten LP-Wechselvorrichtungen, einschließlich der transferstraßenartigen LP-Fördervorrichtung;

Fig. 4     eine Ansicht in etwa längs Linie IV-IV in Fig. 3; und

Fig. 5     eine Draufsicht auf den LP-Aufspanntisch einer der Koordinatenbohrmaschinen nach den Fig. 1 bzw. 2.

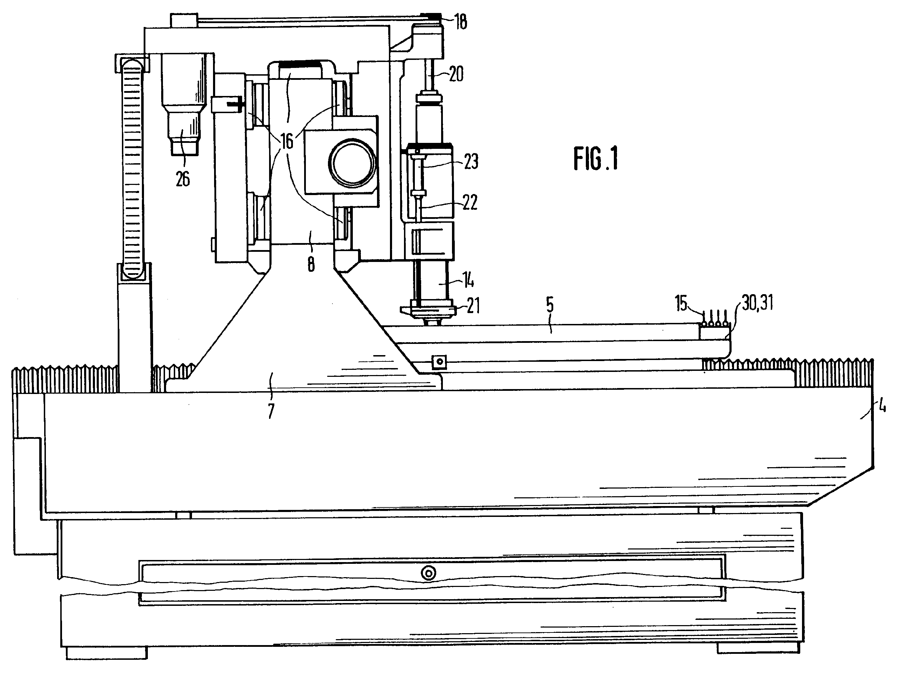

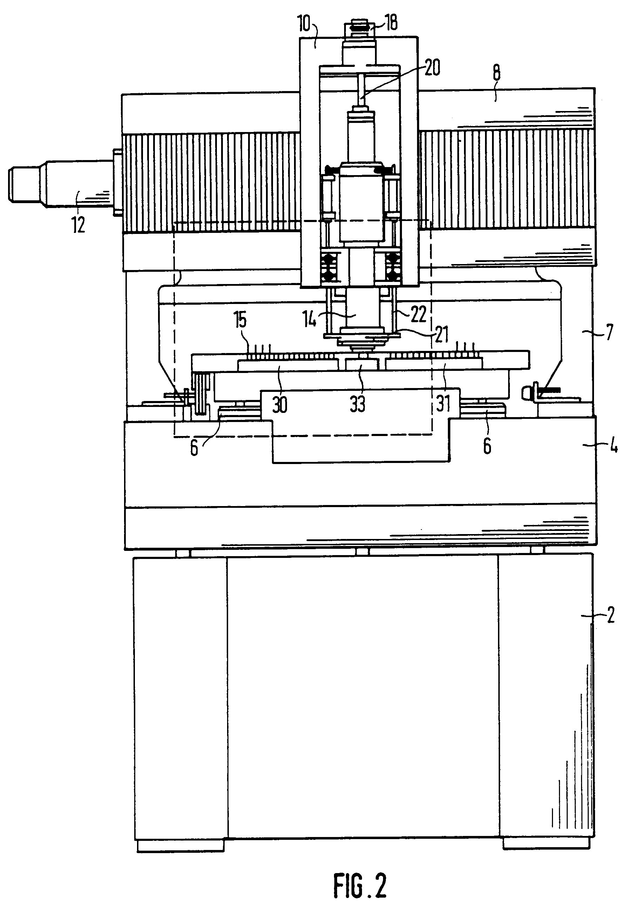

Eine Leiterplatten-Koordinatenbohrmaschine, wie sie in den Fig. 1 und 2 dargestellt ist, gehört mit der zugehörigen Werkzeugwechselanordnung zum Stand der Technik und ist in der EP 287 071 A2 beschrieben. Auf einem Grundgestell 2, welches die komputergestützte elektrische Steuerung für die Koordinatenbohrmaschine enthalten kann, ist eine Grundplatte 4 vorgesehen, die das Bett für den in Richtung der Y-Achse verschieblichen LP-Aufspanntisch (Werkstückspannplatte 5) darstellt, der über Luftlager 6 auf der Oberfläche der Granit-Grundplatte 4 abgestützt ist.

Auf der Grundplatte 4 stützt sich im übrigen über entsprechende Seitenteile 7 auch noch eine brückenartige Traverse 8 für den Traversenschlitten 10 ab, der sich mit Hilfe des X-Achsenantriebes 12 quer zu der Verschiebungsrichtung der Aufnahmeplatte 5 verstellen läßt. Der Traversenschlitten 10 trägt eine Bohrspindeleinheit 14, d.h. den Antrieb und die Lagerung für die in die Bohrspindel 14 integrierte Spannzange (bei 24) zur Aufnahme der eigentlichen Bohrwerkzeuge 15. Der Traversenschlitten 10 ist wiederum über geeignete Axialluftlager 16 gegenüber der Traverse 8 extrem reibungsarm verschieblich. Die Bohrspindeleinheit 14 ist insgesamt in vertikaler Richtung, d.h. in Richtung der Z-Achse verstellbar, um die Bohrtiefenverstellung und andere im Rahmen des Werkzeugwechsels notwendige Bewegungen durchzuführen. Die Bohrspindeleinheit 14 ist ein im Handel erhältliches fertiges Bauteil, das eine zylindrische Gestalt von nicht unerheblicher radialer Ausdehnung aufweist. Die Z-Achsenverstellung der Bohrspindeleinheit erfolgt über einen entsprechenden Antrieb 26, der über einen Riementrieb 18 eine Vorschubspindel 20 verdreht, die letztlich die Axialverstellung der Bohrspindeleinheit 14 bewirkt.

Der der Bohrspindeleinheit 14 zugeordnete Niederhalter 21 wird von Führungsstangen 22 gehalten, die über Druckluftzylinder 23 mit der Bohrspindeleinheit 14 verbunden sind. Während des Bearbeitens von Leiterplatten ist der im Druckluftzylinder 23 enthaltene Kolben auf der oberen Seite mit Druckluft beaufschlagt derart, daß er in Richtung seiner unteren Totpunktlage gedrängt wird. Der Niederhalter befindet sich somit in einer (nicht dargestellten) Stellung unterhalb des fertig eingespannten Bohrwerkzeuges und legt sich zu Beginn der Zustellbewegung der Bohrspindeleinheit in Richtung auf die zu bohrende Leiterplatte an dieser an, um sie federnd nachgiebig niederzuhalten. Der Niederhalter, der koaxial zur Bohrspindeleinheit 14 zwischen dieser und der Werkstückspannplatte 5 angeordnet ist, dient also dazu, die bisweilen sehr großen Leiterplatten im Bereich der gerade durchgeführten Bohrung gegen die Aufnahmeplatte 5 zu drücken, damit sich die nur an ihren Rändern befestigbare Leiterplatte während des Bohrens nicht bewegt bzw. verzieht etc. Außerdem ist der Niederhalter 21 in bekannter Weise gleichzeitig als Saugdüse ausgebildet, um die beim Bohren entstehenden Bohrspäne zu entfernen. Für den Werkzeugwechselvorgang wird der Kolben in dem Druckzylinder 23 auf der unteren Seite mit Druckluft beaufschlagt, so daß der Niederhalter im Verhältnis zur Bohrspindeleinheit 14 nach aufwärts bewegt wird und sich von unten an deren Stirnfläche anlegt.

Am Rande des LP-Aufspanntisches 5, d.h. im dargestellten Ausführungsbeispiel an dem der Bedienungsperson zugewandten stirnseitigen Ende in der Fig. 2 ist mindestens ein Werkzeugmagazin 30 vorgesehen, das beispielsweise in vier 1,5er Reihen insgesamt 60 Werkzeuge aufnimmt. Vorzugsweise kann mindestens ein weiteres Werkzeugmagazin 31 am vorderen Rand des LP Aufspanntisches 5 vorgesehen sein. Wie aus der Fig. 2 ersichtlich ist, ragen die in dem Magazin 30 bzw. 31 gespeicherten Bohrwerkzeuge 15 mit ihrem Einspannschaft nach oben aus dem Magazin heraus, so daß die Bohrspindeleinheit 15 mit ihrer Spannzange (bei 24) bei einer entsprechenden Verstellung in X- bzw. Y-Richtung mit einem ausgewählten Werkzeug in einem der Magazine 30 oder 31 fluchtet und durch eine Zustellung in Z-Richtung das ausgewählte Werkzeug im Magazin vorläufig, d.h. am Anfang des Einspannschaftes ergreift und durch ein Zurückfahren in Z-Richtung aus dem Magazin heraushebt. Der Niederhalter 21 ist an der den Werkzeugen 15 zugewandten Seite mit dem Werkzeugschaftdurchmesser entsprechenden Aussparungen im Raster der Speicherplätze im Magazin versehen, damit die Bohrspindeleinheit 14 zusammen mit der Spannzange überhaupt in die Lage versetzt wird, die Einspannschäfte der sehr dicht im Magazin 30 bzw. 31 gespeicherten Werkzeuge 15 zu ergreifen.

Nach dem Herausziehen des vorläufig ergriffenen, ausgewählten Werkzeuges aus dem Speicherplatz im Magazin wird die Bohrspindeleinheit 14 mit dem daran befindlichen, vorläufig gehalterten Werkzeug derart in X- und Y-Richtung verstellt, daß die Bohrspindel bzw. die Spannzange axial mit einer besonderen Spannstation 33 fluchtet, deren nähere Umgebung von Magazinplätzen freigehalten ist. Um den Einspannschaft des ausgewählten Werkzeuges, das zunächst nur an seinem obersten Ende vorläufig von der Spannzange festgehalten wird, vollends in die Spannzange 24 der Bohrspindeleinheit 14 einzudrücken, wird die Bohrspindeleinheit in Richtung auf die Spännstation 33 so vertikal verstellt, bis ein an jedem Bohrwerkzeug 15 vorgesehener Bund von einer in Axialrichtung federnd gelagerten Hülse in der Spannstation bis zur Anlage an der Spannzange nach oben in diese hinein verschoben worden ist. Die Fig. 2 zeigt diesen Augenblick des Bewegungsablaufes der Werkzeugwechselanordnung.

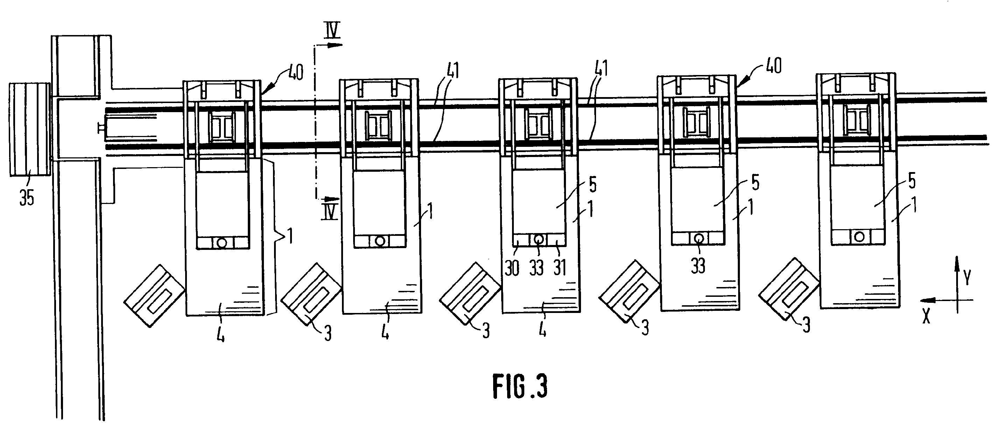

Fig. 3 zeigt in schematisierter Darstellung eine erfindungsgemäße Anordnung von fünf solchen einspindeligen Koordinatenbohrmaschinen 1, wie sie voranstehend unter Bezugnahme auf die Fig. 1 und 2 näher beschrieben wurden. In der Fig. 3 sind die Koordinatenbohrmaschinen nur angedeutet, d.h. insbesondere ist nur die Grundplatte 4 mit dem darauf in Richtung der Y-Achse verschieblichen LP-Aufspanntisch 5 gezeigt. Aus Gründen der einfacheren Darstellung ist der darüber befindliche Aufbau jeder Koordinatenbohrmaschine 1 weggelassen, also insbesondere Seitenteil 7 und Traverse 8, Traversenschlitten 10, Bohrspindeleinheit 14 etc. Allerdings sind die am vorderen Ende des LP-Aufspanntisches 5 angeordneten Werkzeugmagazine 30, 31 und die dazugehörige Spannstation 33 angedeutet, die also auf der der Bedienerperson zugewandten vorderen Seite der Bohrmaschine angeordnet sind, wo sich auch noch das Bedienerpult 3 für die elektronische Steuerung jeder Koordinatenbohrmaschine befindet.

An der von der vorderen Bedienerseite jeder Leiterplatten-Bohrmaschine abgewandten hinteren Stirnseite jeder Bohrmaschine 1 sind spezielle LP-Wechselvorrichtungen oder Maschinenbelader 40 angeordnet, die untereinander durch ein Transportband 41 verbunden sind und über dieses mit ungebohrten Leiterplattenpaketen von einem separaten LP-Vorratsspeicher 35 versorgt werden. Nach Beendigung des Bohrprogramms an einem Leiterplattenpaket wird dieses dann in noch näher zu beschreibender Weise von der Wechselvorrichtung 40 aus der Bohrmaschine 1 entnommen und wieder auf das Transportband 41 gegeben, welches die fertiggebohrten Leiterplattenpakete in Fig. 3 nach rechts zu einem nicht näher dargestellten separaten Ablagespeicher befördert.

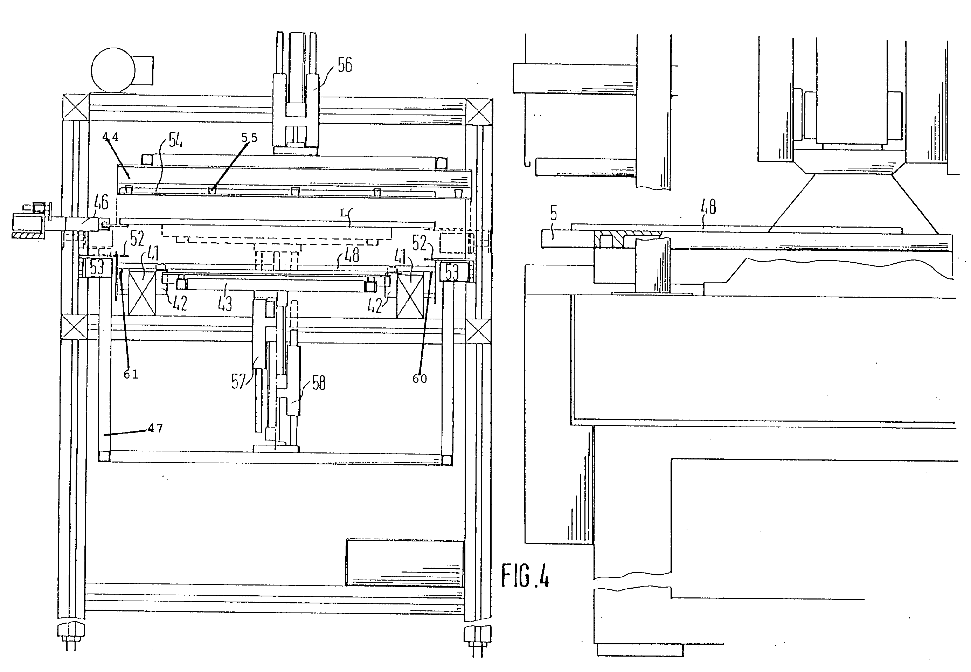

Die Fig. 4 zeigt eine Seitenansicht der LP-Wechselvorrichtung 40 im Zusammenhang mit einer LP-Koordinatenbohrmaschine 1, etwa längs Linie IV-IV in Fig. 3. Etwas unterhalb des von dem Aufspanntisch 5 der Bohrmaschine 1 bestimmten Ladeniveaus für Leiterplattenpakete 48 durchsetzt ein Leiterplattenförderer, der im konkreten Ausführungsbeispiel aus zwei Transportbändern 41 gebildet wird, die Wechselvorrichtung 40 in horizontaler Richtung, d.h. senkrecht zur Zeichenebene der Fig. 4. Auf diesem Transportband 41 abgelegte bzw. vom Vorratsspeicher 35 herangeförderte Leiterplattenpakete 48 können auf ein entsprechendes Signal hin von geeignet ausgebildeten, ausfahrbaren Anschlägen einer Stopeinrichtung 42 unmittelbar über einem Lift 43 angehalten werden, der durch einen in vertikaler Richtung wirkenden Verstellzylinder 57 ausfahrbar ist - etwa auf die in Fig. 4 gestrichelt gezeichnete Höhe, in der sich das Leiterplattenpaket 48 gerade auf dem Ladeniveau des LP-Aufspanntisches 5 befindet.

Oberhalb des auf das Ladeniveau angehobenen Leiterplattenpaketes 48 ist in der LP-Wechselvorrichtung 40 ein Beladespeicher 44 vorgesehen, der mit seitlichen Winkelprofilen 54 versehen und vertikal verfahrbar ist, und zwar über einen Verstellzylinder 56, der am oberen Querholm des Gestells der LP-Wechselvorrichtung 40 befestigt ist. Der Beladespeicher besteht im wesentlichen aus zwei senkrecht zur Laufrichtung des Transportbandes 41 ausgerichteten, parallelen Winkelprofilen 54, auf denen Kegelrollen 55 mit der Spitze nach unten angebracht sind. Diese dienen als Führung für die zu speichernden Leiterplattenpakete. Eines der Winkelprofile 54ist fest gelagert, das andere kann mittels eines Kurzhubzylinders auf das erste zubewegt werden. Dadurch wird das Aufnehmen der Pakete 48 realisiert. Die offene Vorderseite des Beladespeichers grenzt in auf Ladeniveau abgesenktem Zustand an den Aufspanntisch 5 der Bohrmaschine 1. Mit einem vertikal wirkenden pneumatischen Verstellzylinder 56 kann der ganze Beladespeicher zwischen Speicher- und Ladeniveau hin- und herbewegt werden.

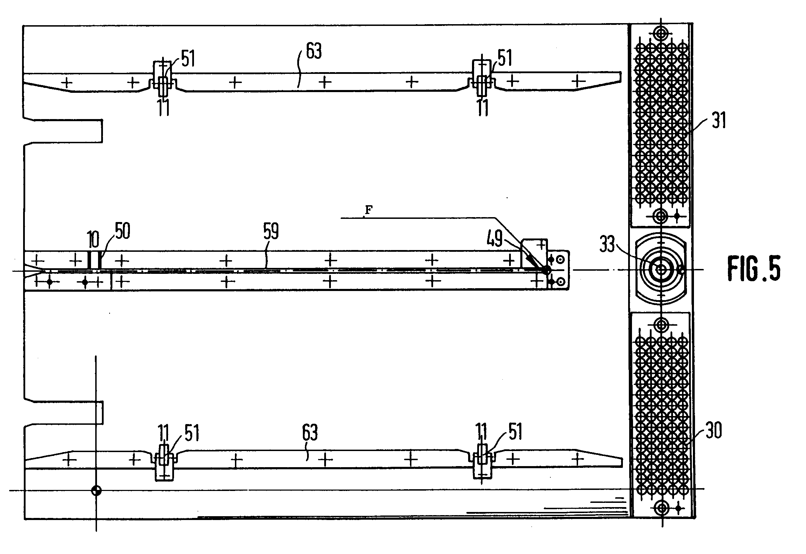

In Höhe des Ladeniveaus ist ein Greifer 46 am Gestell befestigt, mit dem ein Leiterplattenpaket 48 vom Ladeniveau aus in noch zu beschreibender Weise horizontal aus der Wechselvorrichtung 40 auf den Aufspanntisch 5 der Koordinatenbohrmaschine 1 verschoben werden kann. Der Greifer 46 dient zum Verschieben eines unbearbeiteten Werkstücks aus dem Beladespeicher auf den Maschinentisch (Fig. 5) der Bohrmaschine und Zurückziehen eines bearbeiteten Leiterplattenpaketes vom Maschinentisch in den Entladespeicher.

Die Position des Greifers 46 ist auf dem Ladeniveau hinter dem Beladespeicher am Gestell der Wechselvorrichtung. Er besteht im wesentlichen aus zwei untereinander gekoppelten, pneumatischen Greifzangen, denen mittels Kurzhubzylindern das Hinlangen an ein im Beladespeicher befindliches Leiterplattenpaket ermöglicht wird, damit sie es ergreifen können. Die ganze Anordnung des Greifers 46 ist so gelagert, daß sie von einem horizontal befestigten pneumatischen Bandzylinder geführt, eine Bewegung in Richtung des Aufspanntisches 5 der Bohrmaschine 1 und zurück ausführen kann.

Ein vertikal verfahrbarer Entladespeicher 47 ist ebenfalls in der LP-Wechselvorrichtung 40 vorgesehen. Er ist über einen Verstellzylinder 58 vertikal verfahrbar, um ein fertig gebohrtes Leiterplattenpaket 48, das von dem Greifer 46 aus der Bohrmaschine herausgezogen wird, auf dem Ladeniveau zu halten, bis dieses Paket durch den Lift 43 auf das Transportband 41 abgesenkt wird, um auf diesem Wege zum Ablagespeicher befördert zu werden.

Der Entladespeicher besteht im wesentlichen aus zwei Winkelprofilen 52, die in Fig. 4 gesehen rechts und links neben dem Transportband 41 montiert sind und mittels Kurzhubzylindern 53 ihren Abstand voneinander vergrößern bzw. verringern können. In geöffnetem Zustand ist ihr Abstand groß genug, um ein Leiterplattenpaket 48 zwischen ihnen von Bandniveau auf Ladeniveau zu heben, in geschlossenem Zustand wird der Abstand derart verringert, daß ein Paket nicht mehr hindurchpaßt und auf den Winkeln liegen bleibt. Die Winkel sind so gelagert, daß sie gemeinsam von dem pneumatischen Verstellzylinder 58 vertikal vom Ladeniveau zum Zwischenspeicherniveau abgesenkt werden können.

Die Fig. 5 zeigt eine Draufsicht auf einen Aufspanntisch/Maschinentisch 5 einer LP-Bohrmaschine. In Richtung der Y-Achse in der Mitte des Tisches 5 verläuft eine nutenförmige Vertiefung 59, die zur Aufnahme der mittig angeordneten Führungsstifte des Leiterplattenpaketes 48 (siehe auch Fig. 4) vorgesehen ist, wenn letzteres durch den Greifer 46 auf den Tisch aufgeschoben wird. Die seitlichen Führungsleisten 63 sind entsprechend der LP-Breite auf dem Tisch positioniert und führen das Leiterplattenpaket bei diesem Vorgang, dessen Ende durch die Anlage des vorderne Führungsstiftes 62 an einem als Fixpunkt dienenden Prisma bestimmt wird, mit dem ein Primsenhebel 49 zusammenwirkt. Zusätzlich wird das zu bohrende Leiterplattenpaket durch einen Spanner 50 am hinteren Ende der nutenförmigen Vertiefung 59 und durch seitliche Spannhebel 51 im Bereich der Führungsleisten 63 festgelegt. Die Spannelemente 49, 50, 51 könne z.B. pneumatisch betätigt werden.

Die soweit beschriebene Anordnung arbeitet in folgender Weise:

Zum Aufbringen eines Leiterplattenpaketes auf das Transportband 41 wird das am Kopfende des Transportbandes befindliche Magazin (Vorratsspeicher) mit verstifteten Leiterplatenpaketen 48 so weit nach oben gefahren, daß das unterste Paket in der Höhe des Transportbandes steht. Danach fährt ein Abzieher, das ist eine mechanische Einrichtung, mit der die Pakete aus dem Vorratsspeicher 35 auf das Transportband gebracht werden, unter diesen Vorratsspeicher. Das Greifen des Paketes erfolgt rein mechanish. Schließlich fährt des Abzieher zurück unter das Band und nimmt dabei das Paket mit auf das Transportband.

Das Leiterplattenpaket liegt damit auf dem kontinuierlich laufenden Band 41 und wird zu der jeweils zu beschickenden Koordinatenbohrmaschine 1 transportiert, also zu einer der Maschinen 1 in Fig. 3.

Die folgenden Schritte sind maschinenabhängig, d.h. sie werden von der Steuerung der jeweiligen Koordinatenbohrmaschine 1 gesteuert. Zum Beladen einer LP-Wechselvorrichtung 40 fährt die Stopeinrichtung 42 aus. Nachdem durch Auflaufen auf diese Stoppeinrichtung 42 die Rückmeldung kommt, daß das Leiterplattenpaket 48 an der entsprechenden LP-Wechselvorrichtung 40 angekommen ist, bewegt sich der Lift 43 nach oben und bringt das Leiterplattenpaket 48 auf das Ladeniveau. Gleichzeitig senkt sich der Beladespeicher 44 von oben auf das Ladeniveau ab und die Greifer 54 dieses Beladespeichers 44 greifen unter das Leiterplattenpaket 48 und halte es fest. Anschließend hebt sich der Speicher 44 mit dem Paket 48 wieder in die in Fig. 4 gezeigte obere Ruhestellung und der Lift 43 und die Anschläge der Stopeinrichtung 42 senken sich unter das Transportband 41. Damit ist der Beladespeicher 44 dieser betreffenden Maschine 1 beladen, d.h., sie kann aus diesem Speicher 44 beschickt werden. Dazu die folgenden Einzelschritte, die ebenfalls über die Steuerung der Koordinatenbohrmaschine gesteuert werden:

Zum Beladen einer Maschine 1 aus dem Speicher 44 müssen als erstes sowohl Speicher 44 als auch der Aufspanntisch 5 der Maschine 1 in Ladeposition gebracht werden. Das bedeutet beim Speicher 44 ein Absenken auf das Ladeniveau und beim Aufspanntisch dieselbe Stellung, wie sie beim Wechseln des Werkzeuges (Tisch ganz zurück, Traversenschlitten 10 in der Mitte) eingenomen wird. Danach fährt der hinter dem Speicher 44 (in Fig. 4 links davon) angebrachte Greifer 46 so weit vor, daß seine Greifzangen das gespeicherte Leiterplattenpaket packen können, wonach der Greifer 46 das Paket so weit in die Maschine 1 einschiebt, daß der vordere Fangstift 60 des Leiterplattenpaketes 48 am Prisma des Aufspanntisches 5 anschlägt.

Die weiteren Schritte dienen dazu, das auf dem Aufspanntisch 5 liegende LP-Paket 48 zu fixieren. Zu diesem Zweck lösen sich die Greifzangen des Greifers 46. Gleichzeitig spannt der Prismenhebel 49 den vorderen Fangstift 60 ein. Außerdem öffnet sich der Beladespeicher 44 wieder und fährt nach oben in die Ruhestellung (Fig. 4). Nun spannt der Spanner 50 den hinteren Fangstift 61 ein und ein separater, nicht näher dargestellter Einspann-Niederhalter, der mittig am Traversenschlitten 10 befestigt ist, drückt von oben auf das Leiterplattenpaket 48. Gleichzeitig fährt der Greifer 46 ganz zurück in die Ruhestellung der Fig. 4. Zu diesem Zeitpunkt wird das Leiterplattenpaket 48 mittels der Spannhebel 51 rechts und links nach unten auf den Aufspanntisch 5 gedrückt. Das Leiterplattenpaket ist somit sicher auf dem Tisch der Maschine 1 fixiert und der Einspann-Niederhalter kann wieder nach oben fahren. Hiernach kann die Koordinatenbohrmaschine das Bohrprogramm des Paketes 48 abarbeiten.

In dieser Weise können, zeitlich versetzt, alle Koordinatenbohrmaschinen 1 beschickt werden. Wenn die letzte Maschine begonnen hat zu arbeiten, werden nacheinander die einzelnen Speicher 44 der einzelnen LP-Wechselvorrichtungen 40 nachgeladen. Dies erfolgt in der gleichen Weise wie bereits oben beschrieben.

Nachdem das Bohrprogramm der ersten Koordinatenbohrmaschine 1 abgearbeitet ist, wird diese entladen und, um unnötige Ruhezeiten zu vermeiden, sofort wieder aus dem Beladespeicher 44 beschickt. Dazu ist zunächst ein Entladevorgang nötig:

Zum Entladen einer Maschine geht der Aufspanntisch 5 in Ladestellung, d.h. in Fig. 1 oder 4 in die linke Endlage. Gleichzeitig dreht der Entladespeicher 47 die Winkelprofile 52 auf das in Fig. 4 gestrichelt gezeichnete Ladeniveau.

Für den eigentlichen Entladevorgang werden der Prismenhebel 49 und die Spanner 50, 51 gelöst und der Greifer 46 fährt vor in die vordere Endlage, d.h. seine Greifzangen packen das Leiterplattenpaket 48 auf dem Tisch 5 und der Greifer 56 zieht es zurück auf den Entladespeicher in der gestrichelten Position 1 der Fig. 4. Die Greifzangen öffnen sich und der Greifer 46 fährt ganz zurück in die voll durchgezeichnete Position. Hiernach senkt sich der Entladespeicher 47 mit dem fertig gebohrten Leierplattenpaket auf das Zwischenspeicherniveau, auf dem er in Fig. 4 mit voll durchgezogenen Linien eingezeichnet ist: Dadurch wird für ein sofortiges Einwechseln eines im Beladespeicher 44 bereitgehaltenen ungebohrten Leiterplattenpaketes Platz geschaffen. Die Koordinatenbohrmaschine ist nun wieder bereit, aus dem Beladespeicher beschickt zu werden. Dies erfolgt so, wie dies oben beschrieben wurde. Wenn alle Maschinen 1 in den Entladespeicher 47 entladen haben und aus dem Beladespeicher nachgeladen worden sind, beginnt die erste LP-Wechselvorrichtung 40 mit dem Aufbringen des fertiggebohrten Leiterplattenpaketes auf das Transportband 41.

Zum Entladen des Entladespeichers 47 fährt er nach oben in das Ladeniveau und der Lift 43 hebt sich ebenfalls auf das Ladeniveau. Die Winkelprofile 52 öffnen und das Leiterplattenpaket 48 liegt auf dem Lift 43. Schließlich senkt sich der Lift ab und das gebohrte Paket 48 wird auf das Transportband 41 gebracht.

Sobald die Entladespeicher leer sind und das letzte Paket am Ende des Transportbandes angekommen ist, können die Beladespeicher der Reihe nach wieder beschickt werden.

Am Ende des Transportbandes, also in der Fig. 4 ganz rechts, kann eine automatische Stapeleinrichtung mit vorheriger Entstiftung vorgesehen werden. Diese muß ebenso wie die Entnahme der Leiterplattenpakete aus dem Vorratsspeicher 35 separat gesteuert werden.

Zur weiteren Erläuterung der Erfindung wird auf die nachfolgende Beschreibung sowie die beigefügte Bezugszeichenliste verwiesen.

Funktionskomponenten:

1      Zentralmagazin zum Beschicken des Transporbandes
1.1     Zentralbelader
1.2     Abzieher
1.3     Magazinwagen

2      Maschinenbelader
2.1     Stopeinrichtung
2.2     Lift
2.3     Beladespeicher
2.4     Entladespeicher
2.5     Translator

3      Bandentladeeinrichtung mit Entstifter
3.1     Entstifter

3.2 Stapler

4 Transportband

5 Automatische Werkstückspanneinrichtung auf dem Maschinentisch

Kurzbeschreibung des Zusammenwirkens der einzelnen Funktionskomponenten

Anordnung:

Eine oder mehrere alpha 01 sind parallel zueinander in bestimmten Abständen (ca. eine Maschinenbreite = 800 mm) angeordnet. Sie sind mit automatisch spannenden Maschinentischen ausgerüstet. An der der Bedienseite abgewandten Stirnseite befindet sich pro alpha 01 ein Maschinenbelader. Diese sind durch ein Transportband miteinander verbunden. An der Kopfseite dieses Transportbandes ist das Zentralmagazin, am Bandende die Bandentladeeinrichtung mit Entstifter angebracht.

Funktion:

Alle Funktionskomponenten befinden sich in einem genau definierten Grundzutand. Wenn nun eine alpha 01 mit einem Werkstück versorgt werden soll, werden folgende Aktionen, von einem zentralen Leitrechner gesteuert, ausgeführt:

Ein Leiterplattenpaket wird aus dem Zentralmagazin entnommen und mittels des Transportbandes zum Maschinenbelader der zu beschickenden alpha 01 gebracht. Dort wird das Paket zunächst in den Beladespeicher verbracht und von da auf den Maschinentisch der alpha 01, wo es automatisch aufgespannt wird.

Die alpha 01 ist jetzt arbeitsbereit. Nach Abarbeiten des Bohrprogramms durch die maschinenintegrierte CNC-Steuerung wird das bearbeitete Paket vom Maschinentisch auf den Entladespeicher gebracht, wo es zwischengespeichert wird, bevor es auf das Transportband aufgebracht wird, um zur Bandentladeeinrichtung transportiert zu werden. Dort wird das bearbeitete Leiterplattenpaket zunächst entstiftet und dann, in entstiftetem Zustand, in einem geeigneten Stapler gelagert.

Die Funktionskomponenten im einzelnen:

1 Zentralmagazin zum Beschicken des Transportbandes

1.1 Zentralbelader

Funktion: Anheben des Magazinwagens auf Transportbandniveau
Position: Am Kopfende des Transportbandes
Der Zentralbelader ist eine Hubeinrichtung, die einen Magazinwagen aufnehmen, auf Bandniveau anheben und in vorgegebenen Schritten wieder absenken kann. Die Kraft für die Hubbewegung wird von einem kontinuierlich laufenden Drehstrommotor erbracht, der mittels Kupplung und Bremse gesteuert wird; die Positionierung erfolgt durch Rückmeldung über einen optischen Sensor.

1.2 Abzieher

Funktion: Transport eines Leiterplattenpaketes aus dem Magazinwagen im Zentralbelader auf das Transportband.
Position: Am Kopfende des Transportbandes zwischen den Gurtbändern.
Der Abzieher besteht aus einem horizontal wirkenden Pneumatikzylinder, an dessen Kolben eine mechanisch wirkende Klinke angebracht ist, die in eingefahrenem Zustand mit der Vorderkante des Transportbandes abschließt, in ausgefahrenem Zustand bis hinter einen im Zentralbelader befindlichen Magazinwagen reicht.

1.3 Magazinwagen

Funktion: Speichern von mehreren unbearbeiteten Werkstücken
Position: Im Zentralbelader
Der Magazinwagen ist eine Art Regal, in dem verstiftete Leiterplattenpakete gestapelt werden können. Das Fassungsvermögen liegt bei 25 Paketen pro Wagen, die übereinander eingeordnet sind und einen genau definierten vertikalen Abstand voneinander haben. Der Wagen ist mit Rädern ausgerüstet, so daß es möglich ist, mehrere Wagen ohne großen Aufwand gegeneinander auszutauschen.

7

2. Maschinenbelader

2.1 Stopeinrichtung

Funktion:     Festhalten und Positionieren eines auf dem Transportband ankommenden Leiterplattenpakets.
Position:     Direkt am Trägerprofil der Transportbandgurte
    Die Stopeinrichtung besteht aus zwei an den Innenseiten der Transportbandgurte befestigten, kompakten Bauteilen, die pneumatisch betätigt einen Dorn über Gurtbandhöhe ausfahren können, um ein ankommendes Paket am Weiterfahren zu hindern und so zu positionieren, daß es vom Lift abgehoben werden kann.

2.2 Lift

Funktion:     Anheben eines Leiterplattenpakets von Bandniveau auf Ladeniveau
Position:     Zwischen den Gurtbändern, in unmittelbarer Nähe der Stopeinrichtung, direkt unter dem Beladespeicher.

2.3. Beladespeicher

Funktion:     Pufferspeicher für ein unbearbeitetes Leiterplattenpaket zum Beladen einer alpha 01.
Position:     Im Beladergrundgestell, direkt hinter der Aufnahmeplatte der alpha 01.
    Der Beladespeicher besteht im wesentlichen aus zwei senkrecht  zur Bandlaufrichtung ausgerichteten, parallelen Winkelprofilen, auf denen Kegelrollen mit der Spitze nach unten angebracht sind. Diese dienen als Führung für die zu speichernden Leiterplattenpakete. Eines der Winkelprofile ist fest gelagert, das andere kann mittels Kurzhubzylindern auf das erste zubewegt werden. Dadurch wird das Aufnehmen der Pakete realisiert. Die offene Vorderseit des Beladespeichers grenzt in auf Ladeniveau abgesenktem Zustand an den Maschinentisch der alpha 01. Mit einem vertikal wirkenden Pneumatikzylinder kann der ganze Beladespeicher zwischen Speicher- und Ladeniveau hin- und herbewegt werden.

2.4 Entladespeicher

Funktion:     Aufnehmen eines bearbeiteten Leiterplattenpaketes aus der alpha 01 und Zwischenspeichern bis es auf das Transportband entladen werden kann.
Position:     Zwischen Lift und Beladespeicher.
    Der Entladespeicher besteht im wesentlichen aus zwei Winkelprofilen, die rechts und links neben dem Transportband montiert sind und mittels Kurzhubzylindern ihren Abstand voneinander verringern können. In geöffnetem Zustand ist ihr Abstand groß genug, um ein Leiterplattenpaket zwischen ihnen von Bandniveau auf Ladeniveau zu heben, in geschlossenem Zustand wird der Abstand derart verringert, daß ein Paket nicht mehr hindurchpaßt und auf den Winkeln liegen bleibt. Die Winkel sind so gelagert, daß sie gemeinsam von einem Pneumatikzylinder vertikal vom Ladeniveau zum Zwischenspeicherniveau abgesenkt werden können.

2.5 Translator

Funktion:     Verschieben eines unbearbeiteten Werkstücks aus dem Beladespeicher auf den Maschinentisch der alpha 01 und zurückziehen eines bearbeiteten vom Maschinentisch in den Entladespeicher.
Position:     Auf Ladeniveau hinter dem Beladespeicher.
    Der Translator besteht im wesentlichen aus zwei untereinander gekoppelten, pneumatischen Greifzangen, denen mittels Kurzhubzylindern das Hinlangen an ein im Beladespeicher befindlichen Leiterplattenpaket ermöglicht wird, damit sei es ergreifen können. Die ganze Anordnung ist so gelagert, daß sie, von einem horizontal befestigten pneumatischen Bandzylinder geführt, eine Bewegung in Richtung der alpha 10 und zurück ausführen kann.

3. Bandentladeeinrichtung mit Entstifter

3.1 Entstifter

Funktion:     Entstiften von bearbeiteten Leiterplattenpaketen
Position:     Am Transportbandende auf einer ca. 10 Grad geneigten Ebene
    Der Entstifter besteht aus zwei prismenförmig ausgeprägten Metallplatten, die im Abstand der beiden

EP 0 500 525 B1

Fangstifte eines Leiterplattenpakets montiert sind. Über den Zentren dieser Prismen ist je ein Stempel angebracht, der durch Pneumatikzylinder ausführen kann, um die in den Prismen gefangenen Stifte des Leiterplattenpakets herauszudrücken.

3.2 Stapler

Funktion:    Stapeln und Lagern von entstifteten Leiterplatten
Position:    Auf der o,.a. geneigten Ebene, dem Entstifter nachgeschaltet
Der Stapler besteht aus einer Plattform, die mittels Pneumatikzylinder senkrecht zur schiefen Ebene bewegt werden kann um ein entstiftetes Leiterplattenpaket in ein darüberbefindliches Endmagazin zu drücken, wo die Platten festgehalten werden.

4. Transportband

Funktion:    Transport von Werkstücken zu den einzelnen Maschinenbeladern
Postion:    Hinter den zu beschickenden alpha 01
Das Transportband ist aus zwei getrennten, parallelen Gurten aufgebaut, die von einem gemeinsamen Drehstrommotor angetrieben werden (System BOSCH TS2).
Damit sind, bis auf die automatische Aufspannplatte, alle wesentlichen Komponenten beschrieben.
Im folgenden wird ihr Zusammenwirken ausführlicher dargestellt.
Zum automatischen Beschicken einer oder mehrerer alpha 01 die in oben beschriebene Anordnung eingebettet sind, müssen die nachstehend aufgeführten Einzelschritte ausgeführt werden:
Ein mit unbearbeiteten, verstifteten Leiterplattenpaketen bestückter Magazinwagen wird der Schienenanlage des Zentralmagazins manuell zugeführt. Aus einer genau festgelegten Position vor dem Zentralbelader zieht ein Pneumatikzylinder den Wagen in den Zentralbelader hinein. Er wird dabei von der Schienenanlage führt. Nach dem Hineinziehen wird der Wagen durch einen weiteren Pneumatikzylinder dort fixiert. Jetzt hebt der Zentralbelader den Magazinwagen soweit nach oben, daß das unterste Leiterplattenpaket auf Bandniveau zu liegen kommt. In dieser Stellung verharrt der Zentralbelader.
Wenn nun eine der alpha 01 ein Werkstück anfordert, fährt der Abzieher aus und ergreift mittels der am Kolben montierten Klinke das unterste Leiterplatenpaket im Magazinwagen. Beim Einfahren des Abziehers wird es mit auf das kontinuierlich laufende Transportband gezogen. Gleichzeitig ist die Stopeinrichtung der zu beschickenden alpha 01 ausgefahren worden. Nachdem das Paket an der Stopeinrichtung angekommen ist, hebt es der Lift von Bandniveau auf Ladeniveau. Der genau darüber angeordnete Beladespeicher senkt sich zur gleichen Zeit ebenfalls auf Ladeniveau ab. Sobald Lift und Beladespeicher das Ladeniveau erreicht haben, schließt sich der Beladespeicher, indem der Abstand der mit Kegelrollen versehenen Winkel verringert wird soweit, daß das Leiterplattenpaket eingespannt ist. Nun senkt sich der Lift wieder unter Bandniveau und der Beladespeicher hebt sich auf Speicherniveau. Damit ist der erste Teilschritt, das Beschicken des Baldespeichers abgeschlossen.
Als nächstes wird die alpha 01 aus dem Beladespeicher beschickt. Dazu senkt sich dieser auf Ladeniveau ab. Jetzt fahren die Kurzhubzylinder, mit denen die Greifzangen am Translator befestigt sind, so weit aus, daß sie das Leiterplattenpaket zwischen die Greifer bekommen und greifen zu. So fixiert wird das Leiterplattenpaket vom Translator von hinten auf den Maschinentisch geschoben. Die gleichförmige Bewegung wird durch einen pneumatischen Bandzylinder mit entsprechendem Hub ermöglicht. Sobald das Paket seine Endlage auf dem Maschinentisch erreicht hat, lösen sich die Greifer und das Paket wird automatisch auf den Maschinentisch aufgespant. Der Translator und die Greifzangen fahren zurück in ihre Ausgangsposition und die alpha 01 ist bereit, das gespeicherte Bohrprogramm abzuarbeiten.
Wenn alle in der Anordnung befindlichen alpha 01 auf diese Weise beschickt worden sind, werden alle Beladespeicher, wie oben beschrieben, erneut beschickt. So wird gewährleistet, daß jede arbeitende Maschine bereits ein neues Werkstück in unmittelbarer Nähe gespeichert hat.
Nach Abarbeiten des Bohrprogramms muß die alpha 01 wieder entladen werden. Dies geschieht, indem zunächst der Entladespeicher von Zwischenspeicherniveau auf Ladeniveau angehoben und geschlossen wird. Das Schließen erfolgt durch Verringern des Abstandes der beiden Auflagewinkel so, daß ein Leiterplattenpaket nicht mehr hindurchpaßt. Dann fährt der Translator vor, die Greifzangen werden ausgefahren und ergreifen das auf dem Maschinentisch liegende Leiterplattenpaket. Die automatische Spanneinrichtung gibt es frei und der Translator zieht es zurück auf den Entladespeicher. Wenn es dort eine vorgegebene Position erreicht hat, öffnen die Greifer und ziehen sich in ihre Ausgangslage zurück. Der Entladespeicher senkt sich auf Zwischenspeicherniveau ab und verharrt dort.
Nun kann die alpha 01 sofort aus dem Beladespeicher wie oben beschrieben beschickt werden. Sobald

9

alle in der Anordnung befindlichen alpha 01 auf diese Weise entladen und neu beschickt worden sind, müssen die jetzt belegten Entladespeicher auf das Transportband entladen werden. Dazu hebt sich der Lift auf Ladeniveau und hebt dabei das im Entladespeicher befindliche Paket aus. Der Entladespeicher öffnet sich und gibt den Weg nach unten frei.

Der Lift legt das Paket auf das Transportband ab, auf dem es sofort in Richtung zur Bandentladeeinrichtung abgeführt wird. Am Bandende kippt es auf die um 10 Grad geneigte Ebene ab und gleitet auf Rollen in die prismenförmigen Fangeinrichtungen des Entstifters. Wenn die beiden Fangstifte des Pakets ihre Position erreicht haben, drücken die darüber angebrachten Stempel die Fangstifte nach unten heraus. Dadurch verliert das Paket seinen Halt und gleitet weiter in den nachgeschalteten Stapler. Dort wird es von einer Plattform angehoben und so weit in das darüber befindliche Endmagazin gedrückt, daß es festgehalten werden kann. Die Plattform des Staplers senkt sich wieder ab und wartet auf das nächste entstiftete Leiterplattenpaket.

Alle Bewegungen werden über geeignete Sensoren an die Steuerung bzw. den übergeordneten Leitrechner rückgemeldet. Dadurch wird unter anderem erreicht, daß alle Maschinen immer in einem genau definierten Zustand sind und eventuell einzeln abgeschaltet werden können. Auch auftretende Störungen können so rasch lokalisiert und schnell behoben werden. Ein weiterer Vorteil der Sensorik liegt darin, daß das gesamte System vor dem Abschalten in einen genau definierten Grundzustand gesetzt werden kann und so bei einem Neustart keine Probleme auftreten.

Bezugszeichenliste

| | | | |
|---|---|---|---|
| 1 | LP-Bohrmaschine/alpha 01/02 | 32 | |
| 2 | Grundgestell | 33 | Spannstation |
| 3 | Bedienpult für 1 | 34 | |
| 4 | Grundplatte /Granit | 35 | Vorratsspeicher/Zentralmagazin |
| 5 | Aufspanntisch/Maschinentisch | 36 | |
| 6 | Luftlager | 37 | |
| 7 | Seitenteil | 38 | |
| 8 | Traverse/Ausleger | 39 | |
| 9 | | 40 | LP-Wechselvorrichtung/Maschinenbelader |
| 10 | Traversenschlitten | 41 | Transportband |
| 11 | | 42 | Stopeinrichtung |
| 12 | X-Achsenantrieb | 43 | Lift |
| 13 | | 44 | Beladespeicher |
| 14 | Bohrspindeleinheit | 45 | Arbeitstisch |
| 15 | Bohrwerkzeuge | 46 | Greifer/Schieber/Translator |
| 16 | Axialluftlager | 47 | Entladespeicher |
| 17 | | 48 | Leiterplattenpaket (Werkstück) |
| 18 | Riementrieb | 49 | Prismenhebel |
| 19 | | 50 | Spanner |
| 20 | Vorschubspindel | 51 | Spannhebel |
| 21 | Niederhalter | 52 | Winkelprofile Entladespeicher |
| 22 | Führungsstangen | 53 | Kurzhubzylinder Entladespeicher |
| 23 | Druckluftzylinder | 54 | Winkelprofil/Greifer |
| 24 | | 55 | Kegelrollen am Winkelprofil |
| 25 | | 56 | Verstellzylinder/Beladespeicher |
| 26 | Z-Achsen-Antrieb | 57 | Verstellzylinder/lift |
| 27 | | 58 | Verstellzylinder/Entladespeicher |
| 28 | | 59 | Nutenförmige Vertiefung |
| 29 | | 60 | Vorderer Fangstift des LP-Paketes 48 |
| 30 | WZ Magazin | 61 | Hinterer Fangstift des LP-Paketes 48 |
| 31 | WZ Magazin | 62 | |
| | | 63 | Führungsleisten |
| | | L | Ladeniveau |
| | | F | Fixpunkt für MR-Format |

EP 0 500 525 B1

**Patentansprüche**

1. Anordnung zur Beschickung von mehreren, vorzugsweise einspindeligen NC-Leiterplatten-Bohrmaschinen mit zu bohrenden Leiterplatten bzw. zum Abtransport fertig gebohrter Leiterplatten, wobei jede Bohrmaschine aufweist
   - einen LP-Aufspanntisch (5) mit einer Bohrspindeleinheit (14) an einem Ausleger (8)darüber, wobei Tisch und Bohrspindeleinheit relativ zueinander in der Horizontalebene (d.h. in Richtung der X/Y-Achsen) verschieblich sind und die Bohrspindel(n) in Vertikalrichtung(Z-Richtung) verstellbar sind,
   - Bedienelemente (3, 30, 31) im vorderen Bereich der Bohrmaschine,
   - und LP-Wechselvorrichtungen an jeder Bohrmaschine zum Be- und Entladen sowie Zwischenspeichern von fertig gebohrten bzw. ungebohrten Leiterplatten, und wobei
   - mindestens zwei dieser Bohrmaschinen (1) derart nebeneinander angeordnet sind, daß deren X- oder Y-Achsen parallel zueinander verlaufen,
   - die LP-Wechselvorrichtung (40) jeder Bohrmaschine (1) auf der von den Bedienelementen (3, 30, 31) bzw. Zugangsseite abgewandten Seite der Maschine angeordnet sind, und
   - die einzelnen LP-Wechselvorrichtungen (40) untereinander durch einen an den Bohrmaschinen entlang verlaufenden Leiterplattenförderer transferstraßenartig miteinander verbunden sind, der ungebohrte Leiterplätten von einem separaten Votratsspeicher zu den einzelnen LP-Wechselvorrichtungen bzw. fertig gebohrte Leiterplatten von den LP-Wechselvorrichtungen zu einem separaten Ablagespeicher transportiert.

2. Anordnung nach Anspruch 1, dadurch gekennzeichnet, daß der Leiterplattenförderer zwei einen Abstand voneinander aufweisende Transportbänder (41) umfaßt, die parallel zu aber unterhalb der Ebene des Maschinentisches (5) verlaufen und dazwischen Platz für jeweils einen in jeder LP-Wechselvorrichtung angeordneten Lift (43) vorsehen, durch den ein(e) Leiterplatte(npaket) von den Transportbändern (41) auf das vom Maschinentisch (5) bestimmte Ladeniveau anhebbar ist.

3. Anordnung nach Anspruch 2, dadurch gekennzeichnet, daß jeder LP-Wechselvorrichtung (40) ein wahlweise betätigbarer Anschlag einer Stopeinrichtung (42) im Bereich des Leiterplattenförderers zum Arretieren einer darauf befindlichen Leiterplatte über dem Lift (43) zugeordnet ist.

4. Anordnung nach Anspruch 2 oder 3, dadurch gekennzeichnet, daß in jeder LP-Wechselvorrichtung (40) vertikal über dem Lift (43) ein auf das Ladeniveau absenkbarer Beladespeicher (44) angeordnet ist zum Zwischenspeichern und Bereithalten einer auf den Maschinentisch (5) aufzubringenden Leiterplatte.

5. Anordnung nach einem der voranstehenden Ansprüche, gekennzeichnet durch einen jeder LP-Wechselvorrichtung (40) zugeordneten, auf dem Ladeniveau wirkenden und in Richtung auf den Maschinentisch (5) verschieblichen Translator (46) zum Verschieben der Leiterplatte zwischen dem Maschinentisch (5) und der LP-Wechselvorrichtung (40).

6. Anordnung nach einem der voranstehenden Ansprüche, gekennzeichnet durch einen jeder LP-Wechselvorrichtung (40) zugeordneten, zwischen dem Bandniveau und dem Ladeniveau vertikal verfahrbaren Entladespeicher (47) zum Afunehmen einer fertig gebohrten Leiterplatte vom Maschinentisch (5) und Ablegen derselben auf den Transportbändern (41) bzw. zum Zwischenspeichern auf einem Zwischenniveau.

**Claims**

1. An arrangement for feeding a plurality of preferably single-spindle NC printed circuit board drilling machines with printed circuit boards which are to be drilled and for transporting away fully drilled printed circuit boards, wherein each drilling machine comprises:
   - a printed circuit board clamping table (5) having a drilling spindle unit (14) on an arm (8) thereabove, the table and the drilling spindle unit being movable relative to one another in the horizontal plane (that is to say in the direction of the X axis and Y axis) and the drilling spindle(s) being adjustable in the vertical direction (Z direction),
   - operating means (3, 30, 31) in the front region of the drilling machine,
   - and printed circuit board change devices on each drilling machine for loading and unloading and also interim storage of fully drilled or undrilled printed circuit boards,

12

and wherein
- at least two of these drilling machines (1) are disposed side by side in such a manner that their X or Y axes extend parallel to one another,
- the printed circuit board change device (40) of each drilling machine (1) is disposed on the side of the machine remote from the operating means (3, 30, 31) or access side, and
- the individual printed circuit board change devices (40) are connected together in the manner of a transfer line by a printed circuit board conveyor extending along the drilling machines and transporting undrilled printed circuit boards from a separate storage magazine to the individual printed circuit board change devices and fully drilled printed circuit boards from the printed circuit board change devices to a separate delivery magazine.

2. An arrangement according to Claim 1, characterised in that the printed circuit board conveyor comprises two conveyor belts (41) which are spaced apart and which extend parallel to but below the plane of the machine table (5) and leave space therebetween for a lift (43), one such lift being disposed in each printed circuit board change device, by which lift a printed circuit board or printed circuit board packet can be lifted off the conveyor belts (41) to the loading level determined by the machine table (5).

3. An arrangement according to Claim 2, characterised in that each printed circuit board change device (40) has associated with it a selectively actuable stop of a stop device (42) in the region of the printed circuit board conveyor to enable a printed circuit board situated thereon to be halted above the lift (43).

4. An arrangement according to Claim 2 or 3, characterised in that in each printed circuit board change device (40) a loading magazine (44) able to be lowered to the loading level is disposed vertically above the lift (43) for the purpose of interim storage and holding ready of a printed circuit board which is to be deposited on the machine table (5).

5. An arrangement according to one of the preceding claims, characterised by a translator (46), which is associated with each printed circuit board change device (40), and acts at the loading level and which is movable in the direction of the machine table (5), for the purpose of moving the printed circuit board between the machine table (5) and the printed circuit board change device (40).

6. An arrangement according to one of the preceding claims, characterised by an unloading magazine (47), which is associated with each printed circuit board change device (40) and is movable vertically between the belt level and the loading level, for the purpose of receiving a fully drilled printed circuit board from the machine table (5) and depositing it on the conveyor belts (41) or for interim storage at an intermediate level.

## Revendications

1. Dispositif pour alimenter en cartes à circuit imprimé devant être percées plusieurs machines de perçage de cartes à circuit imprimé, de préférence à commande numérique et à une seule broche, et/ou pour évacuer des cartes à circuit imprimé dont le perçage est terminé,
chaque machine de perçage présentant :
- une table (5) de serrage de carte à circuit imprimé, avec une unité à broche(s) de perçage (14) sur une console (8) située au-dessus, la table et l'unité à broche(s) de perçage étant mobiles en translation l'une par rapport à l'autre dans le plan horizontal (c'est-à-dire en direction des axes X/Y et la ou les broches étant mobiles en direction verticale (direction Z));
- des éléments de commande (3, 30, 31) dans la région avant de la machine de perçage;
- et, sur chaque machine de perçage, des dispositifs de changement de carte à circuit imprimé, pour le chargement et le déchargement ainsi que pour l'entreposage de cartes à circuit imprimé dont le perçage est terminé ou qui ne sont pas percées; et
- au moins deux de ces machines de perçage (1) étant agencées l'une à côté de l'autre de manière que leurs axes X ou Y soient mutuellement parallèles;
- chaque dispositif (40) de changement de carte à circuit imprimé de chaque machine de perçage étant agencé du côté de la machine éloigné des éléments de commande (3, 30, 31) ou du côté accès; et
- les dispositifs individuels (40) de changement de carte à circuit imprimé étant mutuellement reliés par une liaison du genre chaîne de transfert au moyen d'un transporteur de cartes à circuit imprimé passant le long des machines de perçage et transportant des cartes à circuit imprimé non percées d'une réserve aux dispositifs individuels de changement de carte à circuit imprimé ou, selon le cas, transportant des cartes à circuit imprimé, dont le perçage est terminé, des dispositifs de changement de carte à circuit imprimé à un moyen de dépôt-stockage séparé.

2. Dispositif selon revendication 1, caractérisé par le fait que le transporteur de cartes à circuit imprimé comporte deux bandes transporteuses (41) séparées par un intervalle, qui passent parallèlement au plan de la table (5) de la machine mais en dessous de celui-ci et offrent dans l'espace intermédiaire à chaque fois de la place pour un élévateur (43) disposé dans chaque dispositif de changement de carte à circuit imprimé, élévateur par lequel une carte à circuit imprimé ou un paquet de telles cartes peut être enlevé des bandes transporteuses (44) et monté au niveau de chargement déterminé par la table (5) de la machine.

3. Dispositif selon revendication 2, caractérisé par le fait qu'à chaque dispositif de changement de carte à circuit imprimé (40) est associée une butée, actionnable sélectivement, d'un dispositif d'arrêt (42) dans la région du transporteur de cartes à circuit imprimé, pour arrêter, au droit de l'élévateur (43), une carte à circuit imprimé se trouvant sur ledit transporteur.

4. Dispositif selon revendication 2 ou 3, caractérisé par le fait que dans chaque dispositif de changement de carte à circuit imprimé (40) est disposé, verticalement au-dessus de l'élévateur (43), un accumulateur de chargement (44) pouvant être descendu au niveau de chargement, pour l'entreposage et le maintien en disponibilité d'une carte à circuit imprimé destinée à être apportée sur la table (5) de la machine.

5. Dispositif selon l'une des revendications précédentes, caractérisé par un translateur (46) conjugué à chaque dispositif (40) de changement de carte à circuit imprimé, opérant au niveau de chargement et mobile en direction de la table (5) de la machine, afin de déplacer en translation la carte à circuit imprimé entre la table (5) de la machine et le dispositif (40) de changement de carte à circuit imprimé.

6. Dispositif selon l'une des revendications précédentes, caractérisé par un accumulateur récepteur de déchargement (47) conjugué à chaque dispositif (40) de changement de carte à circuit imprimé et déplaçable verticalement entre le niveau de la bande et le niveau de chargement, pour recevoir de la table (5) de la machine une carte à circuit imprimé dont le perçage est terminé et déposer celle-ci sur les bandes transporteuses (41) ou, selon le cas, pour l'entreposer à un niveau intermédiaire.

FIG.1

FIG.2

FIG.3

EP 0 500 525 B1

FIG.4

FIG.5